# EUROPEAN PATENT APPLICATION

(11) **EP 4 498 426 A2**
(43) Date of publication of application: **29.01.2025**
(21) Application number: 24189900.4
(22) Date of filing: 19.07.2024
(51) Int. Cl.: H01L 23/00, H01L 23/58

(54) **SEMICONDUCTOR STRUCTURE AND SEMICONDUCTOR DIE**

(30) Priority: 27.07.2023 US 202363515849 P; 26.06.2024 US 202418754687
(71) Applicant: MediaTek Inc., 30078 Hsinchu City (TW)
(72) Inventor: CHENG, Chi-Shun, 30078 Hsinchu City (TW); YU, Yung-Chieh, 30078 Hsinchu City (TW); HSIEH, Yi-Chieh, 30078 Yi-Chieh (TW)
(74) Representative: Haseltine Lake Kempner LLP

(57) **Abstract**

A semiconductor structure and a semiconductor die are provided. The semiconductor structure includes a semiconductor substrate, an electronic circuit, a first seal ring, a buffer zone and a conductive routing. The semiconductor substrate has a circuit region and a seal ring region surrounding the circuit region. The electronic circuit is disposed on the semiconductor substrate in the circuit region. The first seal ring is disposed on the semiconductor substrate in the seal ring region and surrounding the circuit region. The buffer zone is located in the seal ring region and interposed between the circuit region and the first seal ring. The first seal ring is separated from the circuit region by the buffer zone. The conductive routing is disposed on the semiconductor substrate in the buffer zone. The conductive routing is electrically connected to the electronic circuit.

## Description

This application claims the benefit of U.S. Provisional Application No. 63/515,849, filed July 27, 2023, the entirety of which is incorporated by reference herein.

### BACKGROUND OF THE DISCLOSURE

### Field of the Disclosure

The present disclosure relates to a semiconductor structure and a semiconductor die, and in particular, it is related to a seal ring structure of a semiconductor structure and a seal ring structure of a semiconductor die.

### Description of the Related Art

A seal ring is generally formed between the scribe lines and the periphery region of the integrated circuits in each semiconductor die of a wafer. The seal ring is composed by laminating dielectric layers and metal layers. These metal layers are connected through vias that pass through the dielectric layers. When a wafer dicing process is performed along the scribe lines, the seal ring can prevent unwanted cracks in the scribe lines. These cracks may be produced in the integrated circuits by the stress of the wafer dicing process. Also, the seal ring can block moisture, prevent damage from acid or alkaline chemicals, and stop the diffusion of a contaminating species. In the current semiconductor technology, a double seal ring structure has been developed to solve the more significant problem of cracking. However, the occupied area of the seal ring may limit the routing area of the semiconductor die. In high-speed and multi-functional applications, a semiconductor die with a limited routing area may experience electrical problems, such as crosstalk, signal propagation delay, and electromagnetic interference with RF circuits.

Thus, a novel semiconductor die with a seal ring and having improved electrical performance is desirable.

### BRIEF SUMMARY OF THE DISCLOSURE

An embodiment of the present disclosure provides a semiconductor structure. The semiconductor structure includes a semiconductor substrate, an electronic circuit, a first seal ring, a buffer zone and a conductive routing. The semiconductor substrate has a circuit region and a seal ring region surrounding the circuit region. The electronic circuit is disposed on the semiconductor substrate in the circuit region. The first seal ring is disposed on the semiconductor substrate in the seal ring region and surrounding the circuit region. The buffer zone is located in the seal ring region and interposed between the circuit region and the first seal ring. The first seal ring is separated from the circuit region by the buffer zone. The conductive routing is disposed on the semiconductor substrate in the buffer zone. The conductive routing is electrically connected to the electronic circuit.

An embodiment of the present disclosure provides a semiconductor die. The semiconductor die includes a circuit region, a seal ring region, an electronic circuit, a seal ring structure, and a signal routing. The seal ring region surrounds the circuit region. The seal ring region includes a buffer zone surrounding a boundary of the circuit region. The electronic circuit is disposed in the circuit region. The seal ring structure is disposed in the seal ring region and surrounding the circuit region. The seal ring structure is separated from the boundary of the circuit region by the buffer zone. The signal routing is disposed in the buffer zone and extends into the circuit region. The signal routing is electrically connected to the electronic circuit.

### BRIEF DESCRIPTION OF THE DRAWINGS

The present disclosure can be more fully understood by reading the subsequent detailed description and examples with references made to the accompanying drawings, wherein:
FIG. 1 is a top view of a semiconductor device in accordance with some embodiments of the disclosure;
FIG. 2 is a cross-sectional view of a semiconductor device shown along line A-A' in FIG. 1 in accordance with some embodiments of the disclosure; and
FIGS. 3A, 3B and 3C are enlarged views of the semiconductor device in FIG. 2 in accordance with some embodiments of the disclosure, showing the arrangements of a conductive routing in a buffer zone in the seal ring region.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

The inventive concept is described fully hereinafter with reference to the accompanying drawings, in which exemplary embodiments of the inventive concept are shown. The advantages and features of the inventive concept and methods of achieving them will be apparent from the following exemplary embodiments that will be described in more detail with reference to the accompanying drawings. It should be noted, however, that the inventive concept is not limited to the following exemplary embodiments, and may be implemented in various forms. Accordingly, the exemplary embodiments are provided only to disclose the inventive concept and let those skilled in the art know the category of the inventive concept. Also, the drawings as illustrated are only schematic and are non-limiting. In the drawings, the size of some of the elements may be exaggerated for illustrative purposes and not drawn to scale. The dimensions and the relative dimensions do not correspond to actual dimensions in the practice of the disclosure

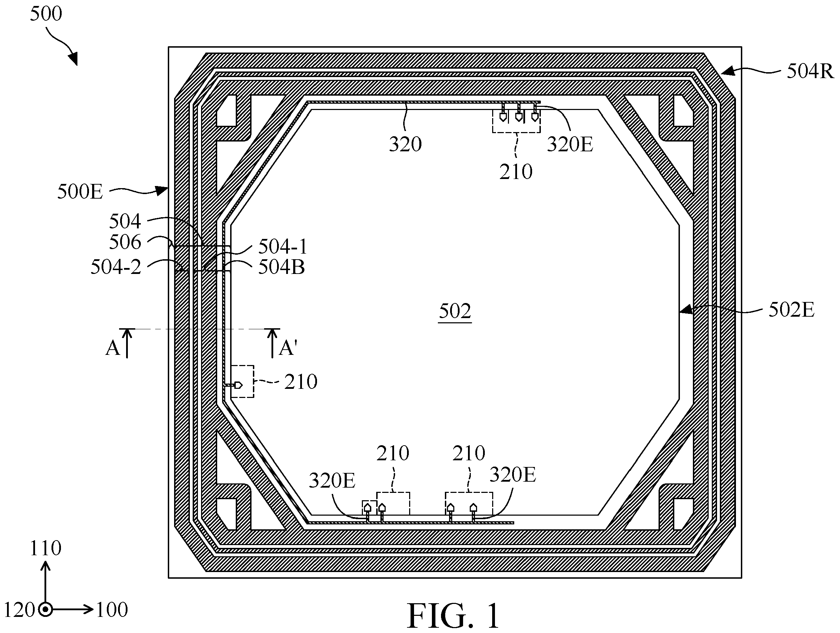

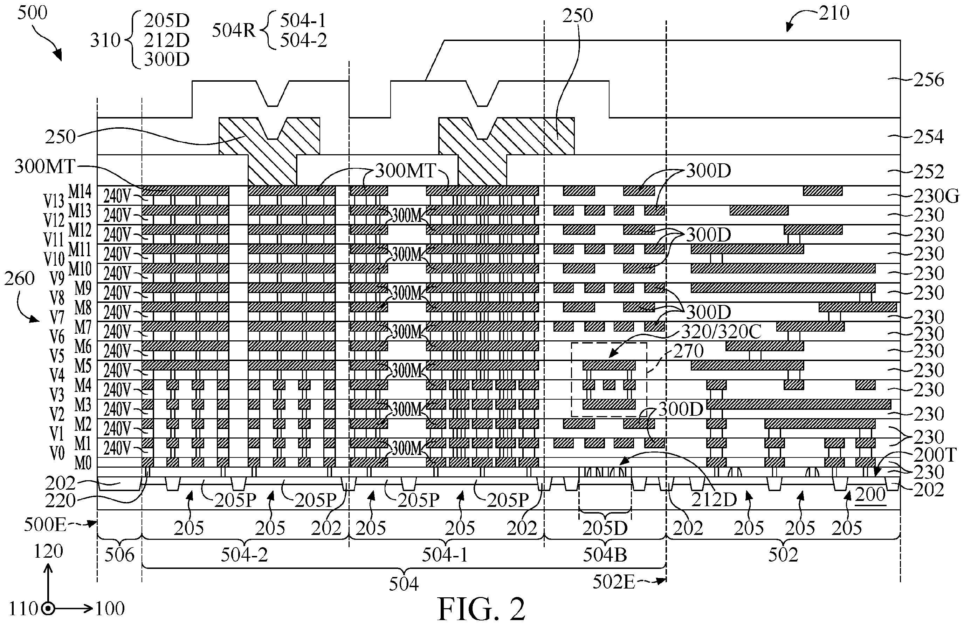

FIG. 1 is a top view of a semiconductor device 500 in accordance with some embodiments of the disclosure. FIG. 2 is a cross-sectional view of the semiconductor device 500 shown along line A-A' in FIG. 1 in accordance with some embodiments of the disclosure. As shown in FIGS. 1 and 2, the semiconductor device 500, such as a semiconductor die 500, includes a semiconductor substrate 200, one or more electronic circuits 210, a seal ring structure 504R (including seal rings 504-1 and 504-2), a buffer zone 504B and a conductive routing structure 320. In FIGS. 1 and 2 and following figures, directions 100 and 110 are directions that are substantially parallel to a top surface 200T of the semiconductor substrate 200 and may also serve as lateral directions. The direction 120 is the direction that is substantially perpendicular to the top surface 200T of the semiconductor substrate 200 and may also serve as the longitudinal (vertical) direction (or may serve as the channel length direction). For clearly showing the arrangements of conductive routing structures 320 in the buffer zone 504B, conductive pads 250, passivation layers 252, 254 and 256 and a dielectric layer 230G are not shown in FIG. 1. Moreover, the direction 100 is perpendicular to the directions 110 and 120, the direction 110 is perpendicular to the directions 100 and 120, and the direction 120 is perpendicular to the directions 100 and 110.

As shown in FIGS. 1 and 2, the semiconductor substrate 200 has a circuit region 502, a seal ring region 504 surrounding the circuit region 502 and a scribe line region 506 surrounding the seal ring region 504. The scribe line region 506 is close to an edge 500E of the semiconductor device 500. In some embodiments, the semiconductor substrate 200 may comprise silicon. In alternative embodiments, SiGe, bulk semiconductor, strained semiconductor, compound semiconductor, semiconductor-on-insulator (SOI), and other commonly used semiconductor substrates can be used for the semiconductor substrate 200. The semiconductor substrate 200 may have the desired conductivity type by implanting p-type or n-type impurities. In some embodiments, an isolation feature 202 including a buried oxide layer and shallow trench isolation (STI) features (not shown) is formed on the top of the semiconductor substrate 200. The isolation feature 202 may surround and provide physical and electrical isolation for active regions 205 on the semiconductor substrate 200. The active regions 205 may be doped with p-type dopants and/or n-type dopants.

The semiconductor device 500 further includes an interconnect structure 260 disposed on the semiconductor substrate 200. In some embodiments, the interconnect structure 260 includes dielectric layers 230 and a dielectric layer 230G, conductive layer patterns (e.g., metal layer patterns) 300M and 300MT, contact plugs 220, and conductive vias 240V.

The dielectric layers 230 and the dielectric layer 230G are disposed on the circuit region 502, the seal ring region 504 and the scribe line region 506 of the semiconductor substrate 200. The dielectric layers 230 are laminated vertically (in the direction 120) on the semiconductor substrate 200. The dielectric layer 230G is disposed on the dielectric layers 230. The dielectric layer 230 may serve as interlayer dielectric (ILD) layer or intermetal dielectric (IMD) layers 230, and the dielectric layer 230G may serve as a topmost intermetal dielectric layer dielectric (IMD) layer 230G. In some embodiments, the dielectric layer 230G disposed on the dielectric layers 230 has a first dielectric constant (k), the dielectric layers 230 disposed between the dielectric layer 230G and the semiconductor substrate 200 has a second dielectric constant (k) that is lower than the first dielectric constant (k). The dielectric layers 230 may be made of a low-k dielectric material (e.g., a dielectric constant that is less than a dielectric constant of silicon dioxide) with a dielectric constant (k) between about 2.9 and 3.8, an ultra low-k dielectric material with a dielectric constant (k) between about 2.5 and 3.9 and/or an extreme low-k (ELK) dielectric material with a dielectric constant (k) less than about 2.5. For example, the dielectric layers 230 may include carbon doped oxide, porous carbon doped silicon dioxide, a polymer such as polyimide or silicon oxycarbide polymer (SiOC), or combinations thereof. In addition, the dielectric layer 230G may be made of a non low-k dielectric material with a dielectric constant (k) greater than about 3.8. For example, the dielectric layer 230G may include silicon oxide, silicon oxynitride, un-doped silicate glass (USG), borosilicate glass (BSG), phosphoric silicate glass (PSG), borophosphosilicate glass (BPSG), fluorinated silicate glass (FSG), or a combination thereof. In some embodiments, the dielectric layer 230G is formed by plasma enhanced chemical vapor deposition (PECVD). It is noted that the number of (low-k) dielectric layers 230 and the number of (non low-k) dielectric layer 230G are defined by the costumer design and the scope of the disclosure is not limited.

In some embodiments, the interconnect structure 260 may have multi levels of conductive layers embedded in the dielectric layers 230 and 230G. For example, as shown in FIG. 2, the interconnect structure 260 may have 15 levels of conductive layers respectively denoted as the first conductive layer M0, the second conductive layer M1, the third conductive layer M2, the fourth conductive layer M3, the fifth conductive layer M4, the sixth conductive layer M5, the seventh conductive layer M6, the eighth conductive layer M7, the ninth conductive layer M8, the tenth conductive layer M9, the eleventh conductive layer M10, the twelfth conductive layer M11, the thirteenth conductive layer M12, the fourteenth conductive layer M13 and the fifteenth conductive layer M14, from bottom to top.

In addition, the interconnect structure 260 may have multi levels of conductive vias alternately arranged with and electrically connected to the conductive layers. For example, as shown in FIG. 2, the interconnect structure 260 may have 14 levels of conductive vias respectively denoted as the first via V0, the second via V1, the third via V2, the fourth via V3, the fifth via V4, the sixth via V5, the seventh via V6, the eighth via V7, the ninth via V8, the tenth via V9, the eleventh via V10, the twelfth via V11, the thirteenth via V12 and the fourteenth via V13, from bottom to top.

One or more electronic circuits 210 are disposed on the semiconductor substrate 200 in the circuit region 502. In some embodiments, the electronic circuit 210 may be located close to a boundary 502E of the circuit region 502. The electronic circuit 210 may be covered by and embedded in the dielectric layers 230. In some embodiments, the electronic circuit 210 may include an analog circuit and/or a RF circuit composed of active elements (such as transistors), passive elements (such as resistors, inductors, and capacitors) and electrical routings (including conductive layer patterns (not shown) belong to the first conductive layer M0 to the fifteenth conductive layer M14 and conductive vias belong to the first via V0 to the fourteenth via V13) connected to the active elements and/or the passive elements. In this embodiments, the electronic circuit 210 may include analog circuit.

As shown in FIGS. 1 and 2, the seal ring structure 504R is disposed on the semiconductor substrate 200 and in the seal ring region 504. The seal ring structure 504R includes the seal ring 504-1 and the seal ring 504-2 separated from each other. The seal ring 504-1 surrounds the circuit region 502, and the seal ring 504-2 surrounds the seal ring 504-1. Also, the seal ring 504-2 is surrounded by the scribe line region 506. The seal ring 504-1 and the seal ring 504-2 may be electrically connected to dope regions 205P (such as P-type doped regions) in the active regions 205 on the semiconductor substrate 200, respectively. The seal ring 504-1 and the seal ring 504-2 are both formed in the interconnect structure 260. The seal ring 504-1 and the seal ring 504-2 are both include the contact plugs 220, the conductive vias 240V and the conductive layer patterns (e.g., metal layer patterns) 300M and 300MT. The conductive layer patterns 300M and 300MT are alternately arranged with and electrically connected to the contact plugs 220 and the conductive vias 240V.

In the seal ring 504-1 and the seal ring 504-2, the contact plug 220 passing through the dielectric layer 230 is connected between the active region 205 and the conductive layer pattern 300M belong to the first conductive layer M0. The conductive vias 240V passing through the corresponding dielectric layers 230 and 230G are connected to the corresponding conductive layer patterns 300M embedded in the corresponding dielectric layers 230 and the conductive layer pattern 300MT embedded in the dielectric layer 230G. The conductive vias 240V may belong to the first via V0 to the fourteenth via V13. The conductive vias 240V may be connected two adjacent levels of between the conductive layer patterns 300M. In addition, the conductive layer patterns 300M and 300MT are located from the bottom-most level (the first conductive layer M0) to the top-most level (the fifteenth conductive layer M14) of conductive layers of the interconnect structure 260. More specifically, the conductive layer patterns 300M may belong to the first conductive layer M0 to the fourteenth conductive layer M13. The conductive layer pattern 300MT may belong to the fifteenth conductive layer M14. In this embodiment, the conductive layer pattern 300MT may also be referred to as a top metal layer pattern 300MT. The conductive layer pattern 300M belongs to the fourteenth conductive layer M13 may also be referred to as a next-to-top metal layer pattern 300M, and so on. The conductive layer patterns 300M belong to the first conductive layer M0 to the thirteenth conductive layer M12 may also serve as lower metal layer patterns 300M. It is noted that the number of contact plugs 220, the conductive vias 240V and conductive layer patterns 300M and 300MT are defined by the costumer design and the scope of the disclosure is not limited.

In some embodiments, the interconnect structure 260 further includes the conductive pads 250 and the passivation layers 252, 254 and 256. The conductive pad 250 covers each of the seal ring 504-1 and the seal ring 504-2 of the seal ring structure 504R. The conductive pads 250 are formed on and electrically coupled to the conductive layer patterns 300MT of the seal rings 504-1 and 504-2. In some embodiments, the conductive pad 250 is formed of aluminum (other metals are applicable and may be used).

The passivation layers 252, and 254 are subsequently deposited above the semiconductor substrate 200 and cover the seal rings 504-1 and 504-2. The passivation layer 252 may have openings (not shown) to expose the conductive pads 250 on the seal rings 504-1 and 504-2. The passivation layer 254 may cover the conductive pads 250. In one embodiment, the passivation layers 252 and 254 are formed of the same material, such as silicon oxide or silicon nitride. In another embodiment, the passivation layers 252 and 254 are formed of different materials. For example, the passivation layer 252 is formed of an inorganic material (e.g., silicon oxide or silicon nitride) and the passivation layer 254 is formed of an organic material (e.g., solder mask). The passivation layer 256 may be optionally deposited on the semiconductor substrate 200 and cover the passivation layer 254. The passivation layer 256 may be formed of polyimide.

As shown in FIGS. 1 and 2, the semiconductor structure 500 may further include a buffer zone (also called seal ring enhanced zone (SREZ)) 504B located in the seal ring region 504. The buffer zone 504B completely surrounds the boundary 502E of the circuit region 502. In addition, the buffer zone 504B is interposed between the circuit region 502 and the seal ring 504-1. The seal ring 504-1 (or the seal ring 504-2) is separated from the circuit region 502 by the buffer zone 504B. The buffer zone 504B may have a suitable lateral dimension. During the formation of the seal ring structure 504R, the buffer zone 504B may prevent the electronic circuits 210 in the circuit region 502 from damage.

In some embodiments, the semiconductor structure 500 may further include dummy patterns 310 disposed on the semiconductor substrate 200 in the buffer zone 504B. The dummy patterns 310 will enhance the mechanical strength of the seal ring structure 504R after the wafer sawing process is performed along the scribe line region 506. In some embodiments, the dummy patterns 310 includes dummy active regions 205D surrounded by isolation features 202 in the semiconductor substrate, dummy poly patterns 212D, dummy conductive patterns 300D or a combination thereof. The conductive patterns 300D may belong to the first conductive layer M0 to the fifteenth conductive layer M14 of conductive layers of the interconnect structure 260. In some embodiments, the dummy patterns 310 are electrically floating.

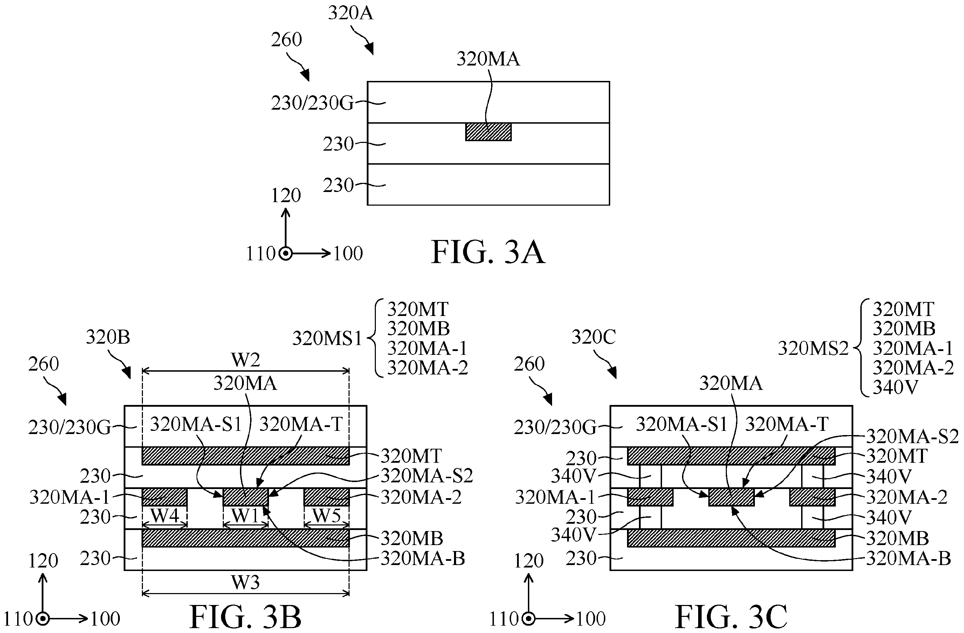

In some embodiments, the buffer zone 504B may provide an additional routing space for the electronic circuits 210 in the circuit region 502. As shown in FIGS. 1 and 2, the semiconductor structure 500 may further include one or more conductive routing structures 320 (including conductive routing structures 320A, 320B and 320C shown in FIGS. 3A, 3B and 3C) disposed on the semiconductor substrate 200 in the buffer zone 504B. The conductive routing structure 320 is disposed in the interconnect structure 260. The conductive routing structure 320 is surrounded by the seal ring structure 504R and electrically connected to the electronic circuit 210 in the top view as shown in FIG. 1. It is noted that the conductive routing structure 320C is merely illustrated as one example of the conductive routing structure 320 in the cross-sectional view as shown in FIG. 2. Various embodiments of the conductive routing structure 320 can be illustrated in FIGS. 3A, 3B and 3C. In addition, the position and the number of the conductive routing structures 320 are not limited to the disclosed embodiments. For instance, the conductive routing structures 320 may be implemented to include one or more conductive layers and/or one or more conductive vias at any levels corresponding to the conductive layers and conductive vias of the interconnect structure 260, such as M0 to M14 and V0 to V13.

As shown in FIGS. 1 and 2, the conductive routing structure 320 may extend substantially along the buffer zone 504B. In addition, the conductive routing structure 320 may extend substantially along and separated from the boundary 502E of the circuit region 502. In some embodiments, the conductive routing structure 320 includes one or more connecting portions 320E extending from the buffer zone 504B to the corresponding electronic circuits 210 in the circuit region 502. The connecting portions 320E are electrically connected to the corresponding electronic circuits 210. In some embodiments, the conductive routing structure 320 is a signal routing structure. For example, the conductive routing structure 320 is used to transmit an analog signal (e.g., a clock signal) while the electronic circuit 210 is an analog circuit. The conductive routing structure 320 is separated from the seal ring 504-1 and the seal ring 504-2. In addition, the conductive routing structure 320 is separated from the dummy patterns 310 in some embodiments.

FIGS. 3A, 3B and 3C are enlarged views of a region 270 of the semiconductor device 500 in FIG. 2 in accordance with some embodiments of the disclosure, showing the arrangements of the conductive routing structures 320A, 320B and 320C disposed in the buffer zone 504B.

In some embodiments as shown in FIG. 3A, the conductive routing structure 320A may include a conductive routing 320MA. The conductive routing 320MA may be embedded in the dielectric layer 230 of the interconnect structure 260. Alternatively, the conductive routing 320MA may be embedded in the dielectric layer 230G of the interconnect structure 260. In some embodiments, the conductive routing 320MA is a signal routing. The conductive routing 320MA is electrically isolated from the seal ring 504-1 and the seal ring 504-2. In some embodiments, the conductive routing 320MA may belong to any levels of conductive layers of the interconnect structure 260 and not limited to the disclosure embodiments. For example, the conductive routing 320MA may belong to any of the first conductive layer M0, the second conductive layer M1, the third conductive layer M2, the fourth conductive layer M3, the fifth conductive layer M4, the sixth conductive layer M5, the seventh conductive layer M6, the eighth conductive layer M7, the ninth conductive layer M8, the tenth conductive layer M9, the eleventh conductive layer M10, the twelfth conductive layer M11, the thirteenth conductive layer M12 and the fourteenth conductive layer M13 and the fifteenth conductive layer M14.

In some embodiments as shown in FIG. 3B, the conductive routing structure 320B may include the conductive routing 320MA and a shielding structure 320MS1. The shielding structure 320MS1 may be disposed in the interconnect structure 260 in the buffer zone 504B. The shielding structure 320MS1 may be embedded in the dielectric layers 230 and 230G of the interconnect structure 260. The shielding structure 320MS1 surrounds and is separated from the conductive routing 320MA in the extending direction (e.g., the direction 110) of the conductive routing 320MA. The shielding structure 320MS1 may help to reduce electrical noise from affecting the signals travelling along the conductive routing 320MA. In some embodiments, the shielding structure 320MS1 is grounded.

In some embodiments, the shielding structure 320MS1 includes conductive layer patterns 320MT, 320MB, 320MA-1 and 320MA-2. In the vertical direction 120, the conductive layer pattern 320MT is located above the top surface 320MA-T of the conductive routing 320MA. The conductive layer pattern 320MB is located below a bottom surface 320MA-B of the conductive routing 320MA. In other words, the conductive layer pattern 320MT and the conductive layer pattern 320MB are located on the opposite surfaces (i.e., the top surface 320MA-T and the bottom surface 320MA-B) of the conductive routing 320MA. In the cross-sectional view as shown in FIG. 3B, the conductive layer patterns 320MA-1 and 320MA-2 are disposed beside opposite side surfaces 320MA-S1 and 320MA-S2 of the conductive routing 320MA in the direction (e.g., the direction 100) that is substantially perpendicular to the extending direction (e.g., the direction 110) of the conductive routing 320MA. The conductive layer patterns 320MT and 320MB may overlap each other in the vertical direction 120. The conductive routing 320MA and the conductive layer patterns 320MA-1, 320MA-2 are interposed between the conductive layer patterns 320MT and 320MB in the vertical direction 120. The conductive layer patterns 320MT and 320MB may overlap the conductive routing 320MA and the conductive layer patterns 320MA-1, 320MA-2 in the vertical direction 120. In addition, the conductive layer patterns 320MT and 320MB may completely cover the top surface 320MA-T and the bottom surface 320MA-B of the conductive routing 320MA. In some embodiments, the conductive layer patterns 320MT, 320MB, 320MA-1 and 320MA-2 are grounded.

In some embodiments, the conductive layer patterns 320MT, 320MB and the conductive routing 320MA belong to different levels of conductive layers of the interconnect structure 260. For example, the conductive layer pattern 320MT is located at a higher level than the conductive routing 320MA in the vertical direction 120. The conductive layer pattern 320MB is located at a lower level than the conductive routing 320MA in the vertical direction 120. For example, in this embodiment, the conductive routing 320MA may belong to the X^{th} conductive layer Mx, where X is a positive integer between 2 and 14, the conductive layer pattern 320MT may belong to the Y^{th} conductive layer M_{Y}, where Y is a positive integer between 3 and 15, and the conductive layer pattern 320MB may belong to the Z^{th} conductive layer Mz, where Z is a positive integer between 1 and 13.

In some embodiments, the conductive layer pattern 320MT and the conductive routing 320MA may belong to adjacent levels of conductive layers of the interconnect structure 260. Similarly, the conductive layer pattern 320MB and the conductive routing 320MA may belong to adjacent levels of conductive layers of the interconnect structure 260. For example, in this embodiment, the conductive routing 320MA may belong to the X^{th} conductive layer Mx, the conductive layer pattern 320MT may belong to the (X+1)^{th} conductive layer M_{(X+1)}, and the conductive layer pattern 320MB may belong to the (X-1)^{th} conductive layer M_{(X-1)}, where X is a positive integer between 2 and 14.

In some embodiments, the conductive layer pattern 320MT and the conductive routing 320MA may separate from each other by at least two levels of conductive layers of the interconnect structure 260. Similarly, the conductive layer pattern 320MB and the conductive routing 320MA may separate from each other by at least two levels of conductive layers of the interconnect structure 260. In some embodiments, the conductive layer patterns 320MT, 320MB may space apart the conductive routing 320MA by the same or different distances in the direction 120. For example, in this embodiment, the conductive routing 320MA may belong to the X^{th} conductive layer Mx, the conductive layer pattern 320MT may belong to the (X+N)^{th} conductive layer M(x+i), and the conductive layer pattern 320MB may belong to the (X-M)^{th} conductive layer M_{(X-1)}, where X, N and M are positive integers, where 2≤ X ≤14, N≥2 and 3≤ (X+N) ≤15, and M ≥2 and 1≤ (X-M) ≤13.

In some embodiments, the conductive layer patterns 320MA-1 and 320MA-2 and the conductive routing 320MA belong to the same level of conductive layers of the interconnect structure 260, as shown in FIG. 3B. In some embodiments, the conductive layer patterns 320MA-1 and 320MA-2 and the conductive routing 320MA belong to the different levels of conductive layers of the interconnect structure 260 and between the between the conductive layer patterns 320MT and 320MB in the vertical direction 120.

As shown in FIG. 3B (in the cross-sectional view in the direction (e.g., the direction 100) substantially perpendicular to the extending direction (e.g., the direction 110) of the conductive routing 320MA), the conductive routing 320MA may have a width W1, the conductive layer pattern 320MT may have a width W2, and the conductive layer pattern 320MB may have a width W3, the conductive layer pattern 320MA-1 may have a width W4, and the conductive layer pattern 320MA-2 may have a width W5. In some embodiments, the width W1 is less than the width W2 and the width W3. In some embodiments, the width W2 and the width W3 may have the same or different values. In some embodiments, the width W4 and the width W5 are both less than the width W2 and the width W3. In some embodiments, the width W4 and the width W5 may have the same or different values. In some embodiments, the width W1, the width W4 and the width W5 may have the same or different values.

In some embodiments as shown in FIG. 3C, the conductive routing structure 320C may include the conductive routing 320MA and a shielding structure 320MS2. At least one of the differences between the shielding structure 320MS1 and the shielding structure 320MS2 is that the shielding structure 320MS2 further includes conductive vias 340V. The conductive vias 340V are located close to the opposite side surfaces 320MA-S1, 320MA-S2 of the conductive routing 320MA. The conductive vias 340V are connected between the conductive layer patterns 320MT and 320MB. In the direction 120, the conductive vias 340V are connected between the conductive layer pattern 320MT and the conductive layer pattern 320MA-1 (or the conductive layer pattern 320MA-2), and between the conductive layer pattern 320MA-1 (or the conductive layer pattern 320MA-2) and the conductive layer pattern 320MB. In addition, the conductive layer pattern 320MA-1 (or the conductive layer pattern 320MA-2) are connected between the conductive vias 340V. Therefore, the conductive layer 320MT is electrically connected to the conductive layer 320MB by the conductive vias 340V and the conductive layer patterns 320MA-1 and 320MA-2. In some embodiments, the number of the conductive vias 340V between the conductive layer pattern 320MT and the conductive layer pattern 320MA-1 (or the conductive layer pattern 320MA-2), and between the conductive layer pattern 320MA-1 (or the conductive layer pattern 320MA-2) and the conductive layer pattern 320MB may be equal to or greater than 1. In some embodiments, the shielding structure 320MS2 is grounded.

Since the buffer zone 504B is used as an additional routing space for the electronic circuits 210 in the circuit region 502, the electronic circuits 210 having the same or similar function may be arranged close to the boundary 502E and electrically connected to each other by the conductive routing structure 320 in the buffer zone 504B. The routing area in the circuit region 502 may be further reduced. When electronic circuits 210 include analog circuits, and the conductive routing structures 320 include the clock signal routings, the interference with other electronic circuits (e.g., RF circuits) in the circuit region 502 may be reduced. When some of the conductive routings are moved to outside the circuit region 502, the routing area in the circuit region 502 may be released to improve routing flexibility. The size of the semiconductor structure 500 (such as a semiconductor die) may be further shrunk.

Embodiments provide a semiconductor structure. The semiconductor structure includes a semiconductor substrate, an electronic circuit, a first seal ring, a buffer zone and a conductive routing. The semiconductor substrate has a circuit region and a seal ring region surrounding the circuit region. The electronic circuit is disposed on the semiconductor substrate in the circuit region. The first seal ring is disposed on the semiconductor substrate in the seal ring region and surrounding the circuit region. The buffer zone is located in the seal ring region and interposed between the circuit region and the first seal ring. The first seal ring is separated from the circuit region by the buffer zone. The conductive routing is disposed on the semiconductor substrate in the buffer zone. The conductive routing is electrically connected to the electronic circuit.

In some embodiments, the conductive routing includes a connecting portion extending from the buffer zone to the circuit region.

In some embodiments, the conductive routing is separated from the first seal ring.

In some embodiments, the semiconductor structure further includes an interconnect structure and a shielding structure. The interconnect structure is disposed on the semiconductor substrate. The shielding structure and the conductive routing are embedded in dielectric layers of the interconnect structure in the buffer zone. The shielding structure surrounds and is separated from the conductive routing. The shielding structure includes a first conductive layer pattern, a second conductive layer pattern and third conductive layer patterns. The first conductive layer pattern is located above the top surface of the conductive routing. The second conductive layer pattern is located below the bottom surface of the conductive routing. The first conductive layer pattern and the second conductive layer pattern overlap each other. The third conductive layer patterns is disposed beside opposite side surfaces of the conductive routing.

In some embodiments, the conductive routing is a signal routing, and the shielding structure is grounded.

In some embodiments, the first conductive layer pattern, the second conductive layer pattern and the conductive routing belong to different levels of conductive layers of the interconnect structure.

In some embodiments, the first conductive layer pattern and the conductive routing belong to adjacent levels of conductive layers of the interconnect structure.

In some embodiments, the second conductive layer pattern and the conductive routing belong to adjacent levels of conductive layers of the interconnect structure.

In some embodiments, the third conductive layer patterns and the conductive routing belong to the same level of conductive layers of the interconnect structure.

In some embodiments, the shielding structure further includes conductive vias close to the opposite side surfaces of the conductive routing. The first conductive layer is electrically connected to the second conductive layer by the conductive vias and the third conductive layer pattern.

In some embodiments, the semiconductor structure further includes dummy patterns disposed on the semiconductor substrate in the buffer zone.

In some embodiments, the dummy patterns are electrically floating.

In some embodiments, the dummy patterns include dummy active regions surrounded by isolation features in the semiconductor substrate, dummy poly patterns, dummy conductive patterns, or a combination thereof.

In some embodiments, the semiconductor structure further includes a second seal ring disposed on the semiconductor substrate in the seal ring region. The second seal ring surrounds the first seal ring. The second seal ring is surrounded by a scribe line region of the semiconductor substrate. The conductive routing is separated from the second seal ring.

In some embodiments, the semiconductor structure further includes an interconnect structure disposed on the semiconductor substrate. The interconnect structure includes dielectric layers, conductive layer patterns and conductive vias. The dielectric layers are laminated on the semiconductor substrate. The conductive layer patterns are embedded in the dielectric layers. The conductive vias are alternately arranged with and electrically connected to the conductive layer patterns. Each of the first seal ring and second seal ring includes the conductive layer patterns alternately arranged with and electrically connected to the conductive vias in the seal ring region. The conductive layer patterns of the first seal ring and second seal ring are located from the bottom-most level to the top-most level of conductive layers of the interconnect structure.

Embodiments provide a semiconductor die. The semiconductor die includes a circuit region, a seal ring region, an electronic circuit, a seal ring structure, and a signal routing. The seal ring region surrounds the circuit region. The seal ring region includes a buffer zone surrounding the boundary of the circuit region. The electronic circuit is disposed in the circuit region. The seal ring structure is disposed in the seal ring region and surrounding the circuit region. The seal ring structure is separated from the boundary of the circuit region by the buffer zone. The signal routing is disposed in the buffer zone and extends into the circuit region. The signal routing is electrically connected to the electronic circuit.

In some embodiments, the semiconductor die further includes a semiconductor substrate, an interconnect structure and a shielding structure. The seal ring structure and the signal routing are disposed on the semiconductor substrate. The interconnect structure is disposed on the semiconductor substrate. The shielding structure is disposed in the interconnect structure in the buffer zone. The shielding structure surrounds and is separated from the signal routing. The shielding structure includes a first conductive layer pattern, a second conductive layer pattern and third conductive layer patterns. The first conductive layer pattern and the second conductive layer pattern are located on opposite surfaces of the signal routing. The third conductive layer patterns are located beside the signal routing and interposed between the first conductive layer pattern and the second conductive layer pattern.

In some embodiments, the shielding structure further includes conductive vias close to opposite side surfaces of the signal routing. The first conductive layer is electrically connected to the second conductive layer by the conductive vias and the third conductive layer pattern.

In some embodiments, the first conductive layer pattern, the second conductive layer pattern and the signal routing belong to different levels of conductive layers of the interconnect structure. The shielding structure is grounded.

In some embodiments, the semiconductor die further includes dummy patterns disposed on the semiconductor substrate in the buffer zone. The dummy patterns are electrically floating.

The semiconductor structure (such as a semiconductor die) uses the buffer zone located in the inner portion of the seal ring region to accommodate the conductive routings connected to the electronic circuits in the circuit region. Therefore, the electronic circuits having the same or similar function may be arranged close to the boundary of the circuit region and electrically connected to each other by the conductive routing structure in the buffer zone. The routing area in the circuit region may be further reduced. When electronic circuits include analog circuits, and the conductive routings include the clock signal routings, the interference with other electronic circuits (e.g., RF circuits) in the circuit region may be reduced. When some of the conductive routings are moved to outside the circuit region, the routing area in the circuit region may be released to improve routing flexibility. The size of the semiconductor structure (such as a semiconductor die) may be further shrunk.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. A semiconductor structure, comprising:
   a semiconductor substrate having a circuit region and a seal ring region surrounding the circuit region;
   an electronic circuit disposed on the semiconductor substrate in the circuit region;
   a first seal ring disposed on the semiconductor substrate in the seal ring region and surrounding the circuit region;
   a buffer zone located in the seal ring region and interposed between the circuit region and the first seal ring, wherein the first seal ring is separated from the circuit region by the buffer zone; and
   a conductive routing disposed on the semiconductor substrate in the buffer zone, wherein the conductive routing is electrically connected to the electronic circuit.
2. The semiconductor structure as claimed in clause 1, wherein the conductive routing comprises a connecting portion extending from the buffer zone to the circuit region.
3. The semiconductor structure as claimed in clause 1, wherein the conductive routing is separated from the first seal ring.
4. The semiconductor structure as claimed in clause 1, further comprising:
   an interconnect structure disposed on the semiconductor substrate; and
   a shielding structure, wherein the shielding structure and the conductive routing are embedded in dielectric layers of the interconnect structure in the buffer zone, wherein the shielding structure surrounds and is separated from the conductive routing, and the shielding structure comprises:
      a first conductive layer pattern located above a top surface of the conductive routing;
      a second conductive layer pattern located below a bottom surface of the conductive routing, wherein the first conductive layer pattern and the second conductive layer pattern overlap each other; and
      third conductive layer patterns disposed beside opposite side surfaces of the conductive routing.
5. The semiconductor structure as claimed in clause 4, wherein the conductive routing is a signal routing, and the shielding structure is grounded.
6. The semiconductor structure as claimed in clause 4, wherein the first conductive layer pattern, the second conductive layer pattern and the conductive routing belong to different levels of conductive layers of the interconnect structure.
7. The semiconductor structure as claimed in clause 4, wherein the first conductive layer pattern and the conductive routing belong to adjacent levels of conductive layers of the interconnect structure.
8. The semiconductor structure as claimed in clause 4, wherein the second conductive layer pattern and the conductive routing belong to adjacent levels of conductive layers of the interconnect structure.
9. The semiconductor structure as claimed in clause 4, wherein the third conductive layer patterns and the conductive routing belong to the same level of conductive layers of the interconnect structure.
10. The semiconductor structure as claimed in clause 4, wherein the shielding structure further comprises:
   conductive vias close to the opposite side surfaces of the conductive routing, wherein the first conductive layer is electrically connected to the second conductive layer by the conductive vias and the third conductive layer pattern.
11. The semiconductor structure as claimed in clause 1, further comprising:
   dummy patterns disposed on the semiconductor substrate in the buffer zone.
12. The semiconductor structure as claimed in clause 11, wherein the dummy patterns are electrically floating.
13. The semiconductor structure as claimed in clause 11, wherein the dummy patterns comprise dummy active regions surrounded by isolation features in the semiconductor substrate, dummy poly patterns, dummy conductive patterns or a combination thereof.
14. The semiconductor structure as claimed in clause 1, further comprising:
   a second seal ring disposed on the semiconductor substrate in the seal ring region, wherein the second seal ring surrounds the first seal ring and is surrounded by a scribe line region of the semiconductor substrate, wherein the conductive routing is separated from the second seal ring.
15. The semiconductor structure as claimed in clause 14, further comprising:
   an interconnect structure disposed on the semiconductor substrate, wherein the interconnect structure comprises:
      dielectric layers laminated on the semiconductor substrate;
      conductive layer patterns embedded in the dielectric layers; and
      conductive vias alternately arranged with and electrically connected to the conductive layer patterns,
   wherein each of the first seal ring and second seal ring comprises the conductive layer patterns alternately arranged with and electrically connected to the conductive vias in the seal ring region, and the conductive layer patterns of the first seal ring and second seal ring are located from a bottom-most level to a top-most level of conductive layers of the interconnect structure.
16. A semiconductor die, comprising:
   a circuit region;
   a seal ring region surrounding the circuit region, wherein the seal ring region comprises a buffer zone surrounding a boundary of the circuit region;
   an electronic circuit disposed in the circuit region;
   a seal ring structure disposed in the seal ring region and surrounding the circuit region, wherein the seal ring structure is separated from the boundary of the circuit region by the buffer zone; and
   a signal routing disposed in the buffer zone and extending into the circuit region, wherein the signal routing is electrically connected to the electronic circuit.
17. The semiconductor die as claimed in clause 16, further comprising:
   a semiconductor substrate, wherein the seal ring structure and the signal routing are disposed on the semiconductor substrate;
   an interconnect structure disposed on the semiconductor substrate; and
   a shielding structure disposed in the interconnect structure in the buffer zone, wherein the shielding structure surrounds and is separated from the signal routing, wherein the shielding structure comprises:
      a first conductive layer pattern and a second conductive layer pattern located on opposite surfaces of the signal routing; and
      third conductive layer patterns located beside the signal routing and interposed between the first conductive layer pattern and the second conductive layer pattern.
18. The semiconductor die as claimed in clause 17, wherein the shielding structure further comprises:
   conductive vias close to opposite side surfaces of the signal routing, wherein the first conductive layer is electrically connected to the second conductive layer by the conductive vias and the third conductive layer pattern.
19. The semiconductor die as claimed in clause 17, wherein the first conductive layer pattern, the second conductive layer pattern and the signal routing belong to different levels of conductive layers of the interconnect structure, and wherein the shielding structure is grounded.
20. The semiconductor die as claimed in clause 17, further comprising:
   dummy patterns disposed on the semiconductor substrate in the buffer zone, wherein the dummy patterns are electrically floating.

## Claims

1. A semiconductor structure, comprising:
a semiconductor substrate (200) having a circuit region (502) and a seal ring region (504) surrounding the circuit region (502);
an electronic circuit (210) disposed on the semiconductor substrate (200) in the circuit region (502);
a first seal ring (504-1) disposed on the semiconductor substrate (200) in the seal ring region (504) and surrounding the circuit region (502);
a buffer zone (504B) located in the seal ring region (504) and interposed between the circuit region (502) and the first seal ring (504-1), wherein the first seal ring (504-1) is separated from the circuit region (502) by the buffer zone (504B); and
a conductive routing (320) disposed on the semiconductor substrate (200) in the buffer zone (504B), wherein the conductive routing (320) is electrically connected to the electronic circuit (210).

2. The semiconductor structure as claimed in claim 1, wherein the conductive routing (320) comprises a connecting portion extending from the buffer zone (504B) to the circuit region (502).

3. The semiconductor structure as claimed in any one of claims 1 and 2, wherein the conductive routing (320) is separated from the first seal ring (504-1).

4. The semiconductor structure as claimed in any one of claims 1 to 3, further comprising:
an interconnect structure (260) disposed on the semiconductor substrate (200); and
a shielding structure (320MS1), wherein the shielding structure (320MS1) and the conductive routing (320MA) are embedded in dielectric layers (230, 230G) of the interconnect structure (260) in the buffer zone (504b), wherein the shielding structure (320MS 1) surrounds and is separated from the conductive routing (320MA), and the shielding structure (320MS1) comprises:
a first conductive layer pattern (320MT) located above a top surface of the conductive routing (320MA);
a second conductive layer pattern (300MB) located below a bottom surface of the conductive routing (320MA), wherein the first conductive layer pattern (300MT) and the second conductive layer pattern (300MB) overlap each other; and
third conductive layer patterns (320MA-1, 320MA-2) disposed beside opposite side surfaces of the conductive routing (320MA).

5. The semiconductor structure as claimed in claim 4, wherein the conductive routing (320MA) is a signal routing, and the shielding structure (320MS1, 320MS2) is grounded.

6. The semiconductor structure as claimed in claim 4, wherein the first conductive layer pattern (300MT), the second conductive layer pattern (300MB) and the conductive routing (320MA) belong to different levels of conductive layers of the interconnect structure (260).

7. The semiconductor structure as claimed in claim 4, wherein the first conductive layer pattern (300MT) and the conductive routing (320MA) belong to adjacent levels of conductive layers of the interconnect structure (260).

8. The semiconductor structure as claimed in claim 4, wherein the second conductive layer pattern (300MB) and the conductive routing (320MA) belong to adjacent levels of conductive layers of the interconnect structure (260).

9. The semiconductor structure as claimed in claim 4, wherein the third conductive layer patterns (320MA-1, 320MA-2) and the conductive routing (320MA) belong to the same level of conductive layers of the interconnect structure (260).

10. The semiconductor structure as claimed in claim 4, wherein the shielding structure (320MS1, 320MS2) further comprises:
conductive vias (340V) close to the opposite side surfaces of the conductive routing (320MA), wherein the first conductive layer is electrically connected to the second conductive layer by the conductive vias (340V) and the third conductive layer pattern (320MA-1, 320MA-2).

11. The semiconductor structure as claimed in any one of claims 1 to 10, further comprising:
dummy patterns (310) disposed on the semiconductor substrate (200) in the buffer zone (504B).

12. The semiconductor structure as claimed in claim 11, wherein the dummy patterns (310) are electrically floating.

13. The semiconductor structure as claimed in claim 11, wherein the dummy patterns (310) comprise dummy active regions (205D) surrounded by isolation features (202) in the semiconductor substrate (200), dummy poly patterns (212D), dummy conductive patterns (300D) or a combination thereof.

14. The semiconductor structure as claimed in any one of claims 1 to 13, further comprising:
a second seal ring (504-2) disposed on the semiconductor substrate (200) in the seal ring region (504), wherein the second seal ring (504-2) surrounds the first seal ring (504-1) and is surrounded by a scribe line region (506) of the semiconductor substrate (200), wherein the conductive routing (320MA) is separated from the second seal ring (504-2).

15. The semiconductor structure as claimed in claim 14, further comprising:
an interconnect structure (260) disposed on the semiconductor substrate (200), wherein the interconnect structure (260) comprises:
dielectric layers (230, 230G) laminated on the semiconductor substrate (200);
conductive layer patterns (300M, 300MT, 320MB, 320MT) embedded in the dielectric layers (230, 230G); and
conductive vias alternately arranged with and electrically connected to the conductive layer patterns,
wherein each of the first seal ring (504-1) and second seal ring (504-2) comprises the conductive layer patterns (300M, 300MT) alternately arranged with and electrically connected to the conductive vias (240V) in the seal ring region (504), and the conductive layer patterns (300M, 300MT) of the first seal ring (504-1) and second seal ring (504-2) are located from a bottom-most level to a top-most level of conductive layers of the interconnect structure (260).
